# EUROPEAN PATENT SPECIFICATION

(11) **EP 1 743 222 B1**
(45) Date of publication and mention of the grant of the patent: **28.09.2011**
(21) Application number: 05742246.1
(22) Date of filing: 04.05.2005
(51) Int. Cl.: G03F 7/20

(54) **OPTICAL COMPONENT HAVING AN IMPROVED THERMAL BEHAVIOR**
OPTISCHE KOMPONENTE MIT EINEM VERBESSERTEN THERMISCHEN VERHALTEN
COMPOSANT OPTIQUE A COMPORTEMENT THERMIQUE AMELIORE

(30) Priority: 06.05.2004 US 568547 P
(43) Date of publication of application: 17.01.2007
(73) Proprietor: Carl Zeiss Laser Optics GmbH, 73447 Oberkochen (DE)
(72) Inventor: EGLE, Wilhelm, 73432 Aalen (DE); HAFNER, Wolfgang, 89551 Königsbronn (DE); ANDERL, Willi, 73460 Hüttlingen (DE); BINGEL, Ulrich, 73457 Lauterburg (DE); MÜNZ, Holger, 73433 Aalen (DE); NEIDHARDT, Thomas, 89520 Heidenheim (DE)
(74) Representative: Heuckeroth, Volker
(86) International application number: PCT/EP2005/004861
(87) International publication number: WO 2005/109104

(56) References cited:
- EP-A- 0 532 236
- EP-A- 1 318 424
- EP-A- 1 394 612
- US-A- 6 144 504
- US-A1- 2002 113 954
- US-A1- 2003 169 520
- PATENT ABSTRACTS OF JAPAN vol. 2003, no. 12, 5 December 2003 (2003-12-05) -& JP 2004 095993 A (NIKON CORP), 25 March 2004 (2004-03-25)
- PATENT ABSTRACTS OF JAPAN vol. 1995, no. 02, 31 March 1995 (1995-03-31) -& JP 06 308294 A (KYOCERA CORP), 4 November 1994 (1994-11-04)

## Description

The invention generally relates to improvements of the thermal behavior of an optical component according to the preamble of claim 1. More specifically, the invention relates to improvements of the thermal behavior of a collector for use in EUV-lithography.

Although the present invention will be particularly described with respect to a collector for use in EUV-lithography, the present invention is not limited thereto.

It is to be understood that, in general, the invention is also useful for other optical components.

An optical component according to the preamble of claim 1 is known from JP 2004 095993 A. This document discloses an optical component of an EUV exposure system, wherein the optical component comprises an active cooling. The optically effective optical element of this optical component is connected to a cooling member in heat conducting fashion, wherein the cooling member includes refrigerant channels through which a cooling medium flows. The optically effective optical element is connected to the cooling member via an intermediate heat-conducting element.

Simulation results for the collector of an illuminating system in the extreme ultraviolet (EUV) range show that the collector strongly heats up in operation. As a consequence of the temperature rise, the collector deforms.

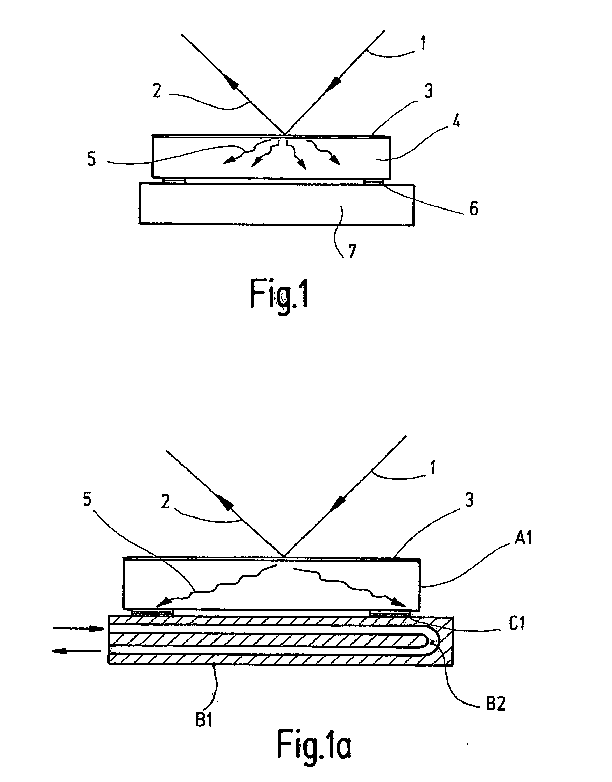

With reference to Fig. 1 of the accompanying drawings, the heating of a general optical component will be briefly explained. Fig. 1 shows an incident optical beam 1 impinging on an optical component. The optical component is, for example, a mirror, comprising a substrate body 4 and an optical layer 3 as the optical element, at which the beam is deviated or reflected as shown by reference numeral 2. Other optical components like lenses, prisms, gratings, beam splitters, etc., are conceivable.

A portion of the impinging energy 1 is absorbed by the optical layer 3 or by the substrate 4. Heat 5 is generated thereby which spreads in the substrate 4. In most cases, this heat is poorly carried off, because the fixing element 6 to the holder 7 and also the substrate material 4 have a poor heat conduction ability. The substrate 4 expands, while this expansion is hindered by the fixing elements 6 and the holder 7, which leads to local deformations of the optical element (substrate and/or optical layer) and, thus, to a deterioration of the optical performance of the device, in which the optical component is used.

Depending on the power of the illumination of the optical system, certain temperatures of the system arise. If no heat carrying off is provided by heat conduction into a cooling medium, the temperatures can become pretty high and rapidly exceed an operating temperature which is in some cases required.

EP 1 387 054 A2 discloses a cooling apparatus and a cooling method for cooling an optical element provided in a vacuum atmosphere. The cooling apparatus includes a radiational cooling part, arranged apart from the optical component for cooling the optical component by radiation heat transfer, and a controller for controlling the temperature of the radiation cooling part.

This cooling apparatus is expensive, because it requires a considerable number of additional parts, thus also increasing the space requirements of the optical component.

US 2004/0051984 A1 discloses devices and methods for cooling devices, optical elements and optical systems, including optical systems used in vacuum environments. The cooling device comprises a heat-receiving plate arranged proximally to a respective optical component along a surface of the optical component at which light directed to the optical component is not incident or outgoing. The heat-receiving plate is configured to receive heat from the optical component. Again, this known device requires a number of parts in addition to the parts of the optical component for cooling same.

US 2003/169520 A1 discloses a system for compensating for heating effects in a mirror. Different areas of the mirror are associated with buried temperature sensors. Each temperature sensor is monitored and used to create a map of current temperatures. The map of current temperatures may be corrected according to baseline values, and then is used to compensate for temperature differences. The temperature effects are controlled by cooling and/or heating control lines.

JP 06 308294 A discloses a mirror, the temperature rise of which is reduced by forming the substrate of the mirror with aluminum nitride ceramic, forming a surface smoothing film on the surface, and forming a reflecting film on it.

US 2002/0113954 A1 discloses a focusing-device for the radiation from a light source, comprising a collector mirror which collects the light from the light source at a second focus in virtual or real terms, in particular for micro-lithography using EUV radiation. The collector mirror can be displaced in direction of the optical axis by means of moveable holding elements. The moveability of the collector mirror is to be provided for maintaining the optical properties of the mirror when heating up in use, thus it being no longer necessary to cool the collector mirror or to keep it at constant temperature.

US-A-6 144 504 discloses a projection and exposure apparatus including an optical member, a holding member for holding the optical member with a gap between the optical member and the holding member, and a powder charged in the gap between the optical member and the holding member such that the optical member and the holding member are maintained in a spaced-apart relationship. This document does not deal with the formal behavior of the optical element.

EP-A-0 532 236 discloses a system for stabilizing the shapes of optical elements and an exposure apparatus using such a system. In order to keep temperature variations of an optical element as small as possible, and thus to avoid deformations of the optical element, it is proposed to provide a heat generator for controlling the temperature distribution of the optical element by a radiation heating. Cooling channels are incorporated in the optical element.

EP-A-1 394 612 describes a lithographic projection apparatus for use in EUV lithography. The apparatus comprises optical components which may be formed by a set of reflectors in the vicinity of the illumination source. In order to avoid deteriorations due to a heating up of the reflectors, it is proposed to coat the reflectors in order to reduce the amount of heat absorbed by the reflectors. The reflector at the exterior of the plurality of reflectors has an infrared radiating layer on the outside, wherein the inner reflectors are coated with an EUV reflective layer on the outside.

It is an object of the present invention to provide another cooling concept for an optical component which is less expensive on the one hand, and on the other hand is nevertheless effective in avoiding or at least reducing deteriorations due to heating effects of the optical component and, thus, of the optical system, in which the optical component is used.

This object is achieved with respect to the optical component mentioned at the outset by the characterizing portion of claim 1.

The concept of the present invention provides to carry off the heat from the at least one optical element of the optical component by means of heat conduction into the at least one holding element which connects the at least one optical element with the carrying structure of the optical component. Thus, the elements of the optical component which are already present are used for the heat carrying off from the at least one optical element so that no or at least not a large number of additional parts are required for this purpose.

According to the invention, the at least one holding element is movable with respect to the carrier structure.

By a movable bearing of the at least one holding element, in particular with respect to the carrier structure, different thermal expansions of the at least one optical element and the at least one holding element are made innocuous in terms of stresses or tensions which could deform the at least one optical element.

The at least one optical element is a mirror, and the at least one holding element is a strut or spoke extending between the mirror and the carrier structure.

In this case, the carrying structure preferably is a ring surrounding the at least one mirror, and the strut or spoke extends radially between the at least one mirror and the ring.

In a preferred embodiment, the at least one holding element is suppliable with a cooling medium.

In particular, the at least one holding element preferably comprises at least one channel for leading the cooling medium through the holding element.

The cooling medium is preferably led through the at least one holding element in a cooling coil forming the at least one cooling channel.

In these embodiments, the at least one holding element is actively cooled by means of a cooling medium, for example water, oil, cooling gas or any other medium which is suited as a cooling medium.

Further, it is preferred if a wall of the at least one holding element in which the at least one channel is present, has an enlarged overlap region overlapping with the at least one optical element.

This measure has the advantage that the heat transfer from the at least one optical element into the at least one holding element is improved.

For further improving the heat transfer from the at least one optical element to the at least one holding element, the wall thickness of the wall of the at least one holding element is preferably thinned at least in the overlap region so that the at least one channel is closely spaced from the optical element by the wall.

In other words, the at least one channel through which the cooling medium is led is arranged in a close distance from the at least one optical element thus improving the heat transfer from the at least one optical element to the at least one holding element.

In a further preferred embodiment, the optical element comprises a substrate wherein the substrate comprises a material which is highly heat-conductive.

A material having a high heat conduction ability is, for example, copper (Cu), while any other heat-conductive material can be used.

Further, in order to improve the heat conduction properties of the substrate, the substrate can comprise completely or partially enlarged or thickened portions.

If the at least one optical element comprises an optically effective layer, this layer preferably comprises a material which is highly heat-conductive.

In a further preferred embodiment, the heat-conductive connecting element or means, by which the at least one optical element is connected to the at least one holding element, is for example a heat-conductive adhesive, a soldering or welding or a heat-conductive mechanical connection.

For example, an adhesive can be used, which is filled with metal particles.

It is further preferred in this connection, if the connecting element or means is thin compared to its contact area with the at least one optical element and the at least one holding element.

This measure further contributes to an improved heat transfer from the at least one optical element to the at least one holding element. In case that the connecting element or means is an adhesive, the adhesive thickness should be as small as possible, thus providing a small gap between the optical element and the holding element. Similarly, if the at least one optical element and the at least one holding element are soldered or welded to each other, the solder or weld thickness should be as thin as possible. In case of a mechanical connecting element, for example a mechanical clamping provides a direct contact between the at least one optical element and the at least one holding element for an improved heat transfer.

It is further preferred, if the at least one holding element comprises a material which is highly heat-conductive.

This measure is also suited for improving the heat transfer from the at least one optical element to the at least one holding element, in particular for transferring the heat from the at least one optical element to the cooling medium flowing through the at least one holding element as provided in one of the before-mentioned embodiments.

In order to achieve a movability of the at least one holding element with respect to the carrier structure, the at least one holding element is preferably connected to the carrier structure by means of at least one leaf spring, and/or by means of at least one solid body joint, and/or by means of at least one slide bearing or at least one roller bearing.

In a further preferred embodiment, a heating system is provided for heating up the optical component to a predetermined operating temperature.

This measure has the advantage that the optical component can be rapidly brought onto the operating temperature which would normally arise after a certain period of irradiation of the at least one optical element of the optical component with light.

The heating system preferably is a contactless heating system.

The heating system preferably comprises a heating shield surrounding the optical component.

Further, in case that the at least one holding element is supplied with a cooling medium, the cooling medium preferably can be heated for heating the optical component to the predetermined operating temperature.

In specific embodiments, the at least one optical element is a mirror, and the at least one holding element is a strut or spoke extending between the mirror and the carrier structure.

In this case, the carrying structure preferably is a ring surrounding the at least one mirror, and the strut or spoke extends radially between the at least one mirror and the ring.

In a further preferred embodiment, the optical component comprises a plurality of optical elements in form of connector shells nested in one another, for example in a substantially concentrical arrangement, and wherein a plurality of radially directed spokes or struts form the holding elements and are connected to at least some or each of the shells.

In this context, it is further preferred, if the spokes are connected to a common outer ring and/or a common inner ring.

As already mentioned, the present invention is in particular useful for an optical component which is a collector for use in EUV-lithography.

Further features and advantages will become apparent from the following description and the accompanying drawings.

It is to be understood that the features mentioned above and those yet to be explained below are not only applicable in the combinations given, but also in other combinations or in isolation without departing from the scope of the present invention.

Some preferred embodiments are shown in the drawings and will be explained hereinafter with reference thereto. In the drawings:
- Fig. 1a: shows a general mirror for explaining the principle of the present invention;
- Fig. 2: shows a collector shell of an EUV-collector having cooled holding struts;
- Fig. 3: shows a corresponding EUV-collector having cooled holding spokes;
- Fig. 4: shows a longitudinal section through a cooled spoke in Fig. 3;
- Fig. 5: shows an embodiment modified with respect to the collector shown in Figs. 2 - 4;
- Fig. 6: shows another embodiment modified with respect to the embodiment shown in Fig. 5; and

- Fig. 7: shows still another embodiment of the invention, wherein a heating system is additionally provided for the optical component.

Fig. 1a generally shows an optical component which is comparable with the optical component shown in Fig. 1. Reference numerals used in Fig. 1a which are identical with those reference numerals in Fig. 1 denote same features as in Fig. 1, and they are not described here again.

Fig. 1a generally shows the heat conduction from an optical element A1 of the optical component into the holder or holding element B1 according to the present invention. The optical element of the optical component comprises a substrate A1 made of a highly heat-conductive material (for example copper, aluminum, SiC) and having a large cross-section. The holder B1 comprises one or several cooling channels B2 which is or which are flown through by a cooling medium. The optical element A1 is connected to the holding element B1 by means of a highly heat-conductive connecting element or connecting means C1 which has one or several of the following characteristics: a large contact area for contacting the optical element A1 and the holding element B1, a small thickness, a good heat conduction, and the formation of a small gap between the optical element A1 and the holding element B1. The connecting element or connecting means is, for example, an adhesive filled with metal particles or graphite. Instead of an adhesive, a mechanical clamping mechanism can be used in order to connect the optical element A1 to the holding element B1.

The configuration shown in Fig. 1a offers a good carrying off of heat from the optical element A1 which, thereby, is only slightly heated up. Thermal deformations are reduced due to the reduced heating up.

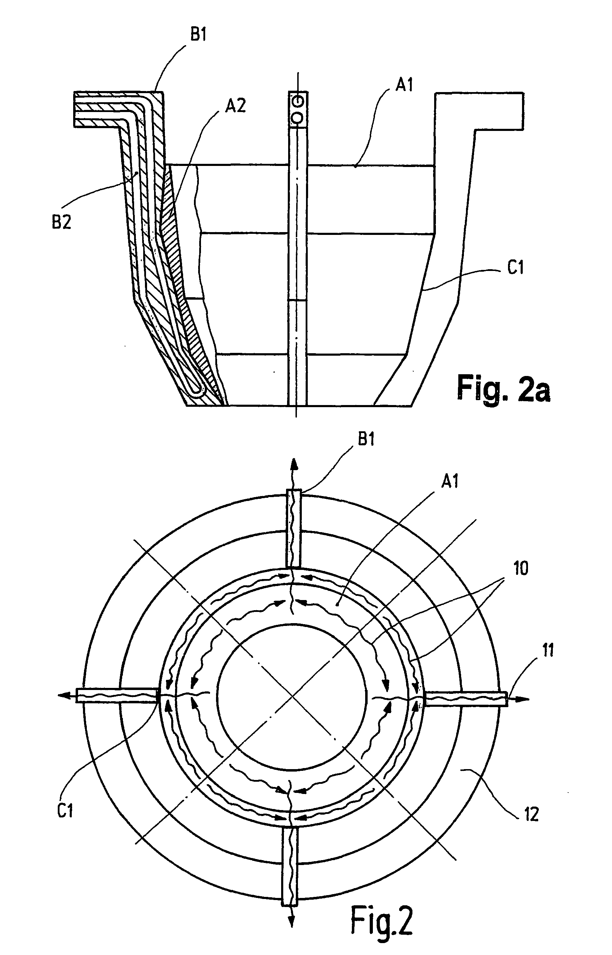

Fig. 2 shows an optical component comprising a collector mirror shell A1 as the optical element and, connected thereto, four struts B1 as the holding elements.

Heat 10 absorbed by the collector mirror shell A1 is carried off by the cooled struts B1, as indicated with reference numeral 11. The number of four struts B1 which are arranged at the periphery of the shell A1 is only exemplary, and can be larger or smaller than four. The struts B1 are integrated in an outer ring 12, which serves as carrying structure or holder and which includes fixing elements to a housing or a mounting or a carrier (not shown).

The struts B1 are in contact with the shell A1 by means of connecting elements or means C1, as described in connection with Fig. 1a.

As shown in the upper part of Fig. 2, the struts B1 comprise one or several channels B2 for passing through the cooling medium as already described with respect to Fig. 1a.

It is possible to combine a plurality of shells A1 by fitting same into one another. Fig. 2 only shows the holding element B1 of a single shell A1.

In principle, it is also possible to cool larger surfaces or areas of the optical element A1. For example, the struts B1 which are arranged in the optically not effective region or in the optical shadow region of the optical element A1 could be designed broader, and, if the need arises, could even extend over the entire periphery of the shell A1. Further, cooling channels could also run in azimuthal direction. The advantage of the present concept resides in the simple design of the cooling system, and is, further, founded in the fact that the risk of applying deformations by the integration process (gluing, welding, soldering, clamping etc.) is reduced in the present concept. Azimuthal thermal gradients can be preferably avoided by expanding or thickening the substrate of the shell A1 as indicated by reference numeral A2 and by using a material for the substrate which shows an enhanced heat conduction characteristic.

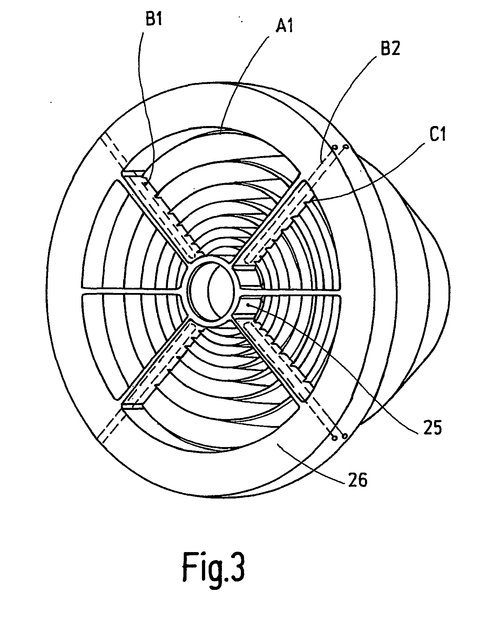

Fig. 3 shows an optical component in form of an EUV collector comprising a plurality of collector shells A1 which are nested into one another in concentric fashion, and which are glued in a spoke wheel as indicated with reference numeral C1, wherein the spokes B1 of the spoke wheel comprise cooling channels B2, which are flown through by a cooling medium as already described above.

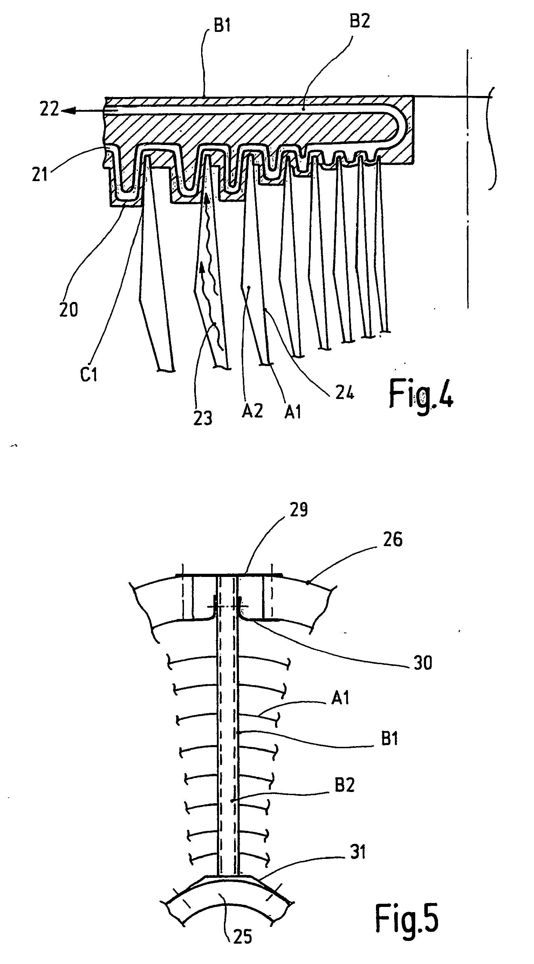

Fig. 4 shows a sectional view through one of the spokes B1.

The amount of heat 23 absorbed in a collector shell A1 at the optical mirror surface 24 is carried off along the collector shell A1 into the cooled strut or spoke B1 of the spoke wheel (confer Fig. 3). Each of the spokes B1 which form the holding elements of this optical component comprises an integrated cooling line or channel B2, in which a cooling medium is supplied 21 and carried off (22) again. The heat transport is supported by a shell material of the collector shells A1 having a good heat conduction property, for example copper, and by thickened or expanded regions A2 of the collector shells A1 in the shadow region of the collector.

The heat transition from each of the shells A1 into the spokes B1 can be further improved by the following preferred structural elements:
- an overlap region between the optical shell A1 and the spoke B1 as large as possible and having an area as large as possible which can be made possible by lowering or providing the spokes B1 with protrusions 20;
- fixing the shells to the spokes B1 by means of a connecting element or means C1 having a good heat conduction property, for example a heat conducting adhesive;
- minimizing the thickness of the connecting elements or means C1, thereby minimizing the gap between the shells A1 and the spokes B1;
- as an alternative soldering or welding instead of gluing the shells A1 to the spokes B1;
- as another alternative, a mechanical connection of the shells A1 to the spokes B1, for example by clamping, screwing, etc.;
- a wall thickness as small as possible of the wall of the spokes B1 in the overlap region between the spokes B1 and the shells A1 so that the shells A1 are closely adjacent to the cooling channels B2 in the spokes B1;
- providing the spokes made of a material having a high heat conduction property (for example copper or aluminum); and/or
- disposing the spokes B1 in an intermediate region between the ends of the shells A1 instead of disposing the spokes B1 at the edge or end of the shells A1 as shown in Figs. 3 and 4.

By suitably choosing the wall thicknesses A2 of the shells A1, the wall thickness of the spokes B1 in the overlap region or in the region of the separation joint C1 and the cooling channels B2 and of the thickness of the connection element C1, it is possible to achieve that a higher and determinable temperature arises on the collector shells A1. This fact can be used to achieve that the same temperature arises for all shells A1 of the collector within a certain tolerance. A heating of the collector and a change of the shape in connection therewith then can be corrected by suited methods (for example displacing the light source or the collector), because the temperature distribution now is approximately homogenous. The same can be achieved for a collector in Fig. 2 having cooled holding struts, i.e. a homogenous temperature can be achieved in this manner.

Deformations of the shells A1 can occur, in particular in the region of the connecting elements or means C1 where the shells A1 and the spokes B1 are connected to each other, due to different thermal expansion properties of the spokes or the spoke wheel and the collector shells A1. Such deformations are minimized by bearing the spokes B1 such that they are movable, in particular radially free movable, while they preferably are stiff in other directions than the radial direction.

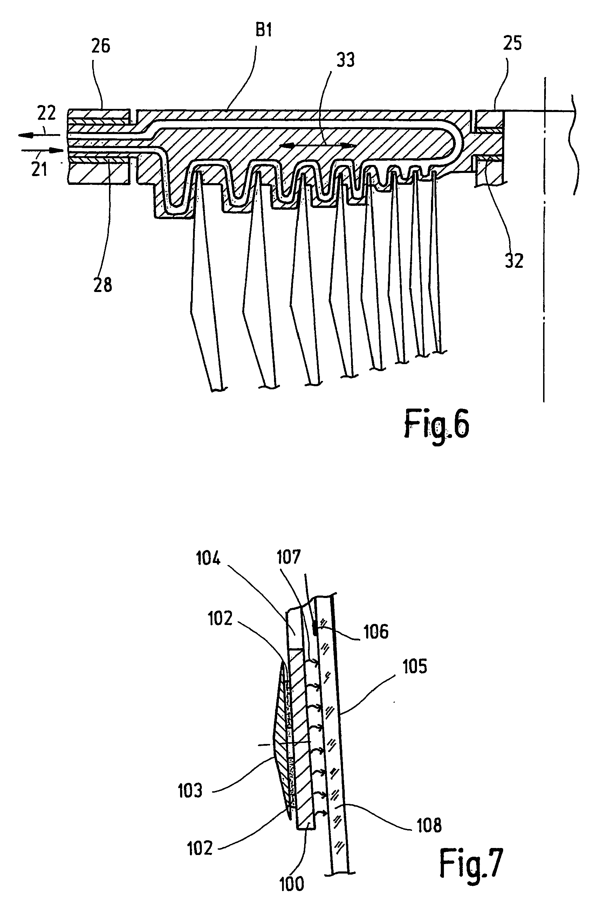

Figs. 5 and 6 show two variants for such a movability.

Fig. 5 shows a solution comprising leaf springs. To this end, those spokes B1, in which a cooling system B2 is integrated, are fixed to an outer ring 26 of the spoke wheel via leaf springs 29, 30. Such a spoke B1 is also fixed to an inner ring 25 via a leaf spring 31.

As an alternative, the spoke wheel could be produced monolithically with integrated solid body joints, or, instead of leaf springs, small single elements with solid body joints could be used.

Fig. 6 shows a solution having a slide bearing. Those spokes B1, which are flown through by a cooling medium 21, 22, are mounted in bearings in the spoke wheel 25, 26 by means of two slide bearings 28, 32. When the collector shells A1 expand, the spokes can move radially 33 together with the collector shells A1.

The slide bearings could be omitted. As an alternative to the described solution having bolts and bores, the spokes B1 could also be connected to the fixed parts 25, 26 of the spoke wheel by means of a pin and could slide on the pin.

Roller body-linear-guidings could also be used instead the slide bearings 28, 32.

In the following, manufacturing methods for manufacturing the EUV-collector shells A1 for the present invention are described.

The shells A1 can be manufactured from a highly heat-conductive material (for example copper) by electroforming. In this conjunction, it is also possible to locally thicken (A2 in Fig. 4) the shells A1 by means of a suited masking during the manufacturing process so that the shadow regions of the collector are optimally filled up for the purpose of an improved heat conduction. Even in those cases where the shells are made of a material having a lower heat conduction coefficient (for example nickel), the thickening of the shells A1 results in a considerably improved heat carrying off from the shells A1.

In some cases, thermal gradients and deformations of the optics produced by the thermal gradients cannot be completely removed even if the cooling concept used is the best available. In any case, an operating temperature will arise in a steady state which is higher than the initial temperature of the system. A further improvement, therefore, is the use of an additional heating system. The optical elements should be rapidly heated up to the operation temperature, and the temperature of the optical component (for example of the EUV-collector shells) should be kept constant subsequently, by reducing the heating power of the additional heating slowly, so that, in the steady state, the optical component is completely heated by the absorbed power of the actual illumination.

The transient effect of the system during operation (change of temperature and, thus, deformations and optical performance) are still further minimized in this manner.

This system requires a temperature control, wherein the temperature at the optical component can be permanently measured by means of a temperature sensor applied thereto, and the heating power of the additional heating is controlled, accordingly. Only if the optical component has achieved the operation temperature by means of the additional heating, the system is ready for operation. This requires that a certain time of heating up is allowed, before the system is switched on or is ready for operation.

A contactless concept for such an additional heating is preferred, so that deformations of the optical element of the optical component due to the application of heating elements can be avoided - confer Fig. 7. In principle, heating shields can be used arranged around or surrounding the shells A1, which apply the heating power onto the optical parts 108 by means of radiation 107. Such heating shields can comprise a carrying body 101, heating foils (or heating mats) 102, several plates 103 for pressing and a carrying frame 104 (confer Fig. 4). The carrying frame and the heating shields are situated in the not used shadow regions of the optical component. The optically usable region or surface is situated on another site 105 of the optical component. Some temperature sensors 106 are also applied onto the optical parts of the optical component, in order to measure the temperature to be adjusted.

In case that the heating elements cannot be arranged around the entire optical components for the reason of space requirements, it is advantageous if the substrate 108 comprises a highly heat-conductive material (for example copper) and is optimally thickened up as described above.

As an alternative, the heating shields could also include a heating spiral or induction coils. The solution having heating foils/-mats, however, offers a very flat and space-saving solution which includes commercially available heating elements.

In case that a minimum temperature is required, which is higher than the initial temperature in the switched-off state, this minimum temperature is reached only after a certain time period in a normal operation. The system can be more rapidly preheated to the operation temperature by means of an additional heating. This temperature can be necessary for the operation or for any service or cleaning cycles.

Furthermore, an additional heating system can be provided for achieving a required system temperature. Such a heating can be configured as described before. It is also conceivable that the cooling medium as described above is heated up via a heat exchanger and, thus, heats up the system. It is also conceivable that the temperature of the cooling medium can be controlled between hot and cold. As an alternative, the hot medium could be lead through the channels of the cooling system for the purpose of heating up, while, in the normal operation, it is then switched over to a cool medium for cooling. In this case, the hot and the cool medium should be the same, for example oil or water, the boiling point of which is far beyond 100°C in an overpressure condition.

## Claims

1. An optical component for an EUV lithography exposure apparatus, comprising at least one optically effective optical element (A1) which heats up when irradiated with light, and at least one holding element (B1) for the at least one optical element (A1) for holding the at least one optical element (A1) in a carrier structure, wherein the at least one optical element (A1) is connected to the at least one holding element (B1) in heat conducting fashion, and wherein the at least one holding element (B1) is at least partially provided with an active cooling system for carrying off heat from the at least one optical element (A1), wherein the at least one optical element (A1) is connected to the at least one holding element (B1) by means of a heat conductive connecting element or means (C1), **characterized in that** the at least one holding element (B1) is movable with respect to the carrier structure.

2. The optical component of claim 1, **characterized in that** the at least one holding element (B1) is suppliable with a cooling medium.

3. The optical component of claim 2, **characterized in that** the at least one holding element (B1) comprises at least one channel (B2) for leading the cooling medium through the holding element (B1).

4. The optical component of claim 3, **characterized in that** a wall of the at least one holding element (B1) in which the at least one channel (B2) is present, has an enlarged overlap region overlapping with the at least one optical element (A1).

5. The optical component of claim 4, **characterized in that** the wall thickness of the wall of the at least one holding element (B1) is thinned at least in the overlap region so that the at least one channel (B2) is closely spaced from the optical element (A1) by the wall.

6. The optical component of anyone of claims 1 through 5, **characterized in that** the at least one optical element (A1) comprises a substrate, wherein the substrate comprises a material which is highly heat conductive.

7. The optical component of anyone of claims 1 through 6, **characterized in that** the at least one optical element (A1) comprises an optically effective layer, wherein the layer comprises a material which is highly heat conductive.

8. The optical component of anyone of claims 1 through 7, **characterized in that** the heat conductive element or means (C1) is provided by a heat conductive adhesive, by soldering or welding or a heat conductive mechanical connection.

9. The optical component of anyone of claims 1 through 8, **characterized in that** the at least one holding element (B1) comprises a material which is highly heat conductive.

10. The optical component of anyone of claims 1 through 9, **characterized in that** the at least one holding element (B1) is connected to the carrier structure by means of at least one leaf spring (29, 30, 31).

11. The optical component of anyone of claims 1 through 10, **characterized in that** the at least one holding element (B1) is connected to the carrier structure by means of at least one solid body joint.

12. The optical component of anyone of claims 1 through 11, **characterized in that** the at least one holding element (B1) is connected to the carrier structure by means of at least one slide bearing or at least one roller bearing (28, 32).

13. The optical component of anyone of claims 1 through 12, **characterized in that** a heating system is provided for heating up the optical component to a predetermined operating temperature.

14. The optical component of claim 13, **characterized in that** the heating system is a contactless heating system.

15. The optical component of claim 13 or 14, **characterized in that** the heating system comprises a heating shield surrounding the optical component.

16. The optical component of claim 2 or 3 and anyone of claims 10 through 15, **characterized in that** the cooling medium can be heated for heating the optical component to the predetermined operating temperature.

17. The optical component of anyone of claims 1 through 16, **characterized in that** the at least one optical element (A1) is a mirror, and the at least one holding element (B1) is a strut extending between the mirror and the carrier structure.

18. The optical component of claim 17, **characterized in that** the carrying structure is a ring surrounding the at least one mirror, and the strut extends radially between the at least one mirror and the ring.

19. The optical component of anyone of claims 1 through 18, **characterized in that** it comprises a plurality of optical elements (A1) in form of collector shells nested in one another, and wherein a plurality of radially directed spokes form the holding elements and are connected to at least some or each of the shells.

20. The optical component of claim 19, **characterized in that** the spokes are connected to a common outer ring and/or a common inner ring.

21. The optical component of anyone of claims 1 through 20, **characterized in that** it is a collector for use in EUV lithography.

## Patentansprüche

1. Optisches Bauteil für EUV-Lithografiebelichtungsvorrichtung, mit zumindest einem optisch wirksamen optischen Element (A1), das sich erwärmt, wenn es mit Licht bestrahlt wird, und zumindest einem Halteelement (B1) für das zumindest eine optische Element (A1), um das zumindest eine optische Element (A1) in einer Tragstruktur zu halten, wobei das zumindest eine optische Element (A1) mit dem zumindest einen Halteelement (B1) wärmeleitend verbunden ist, und wobei das zumindest eine Halteelement (B1) zumindest teilweise mit einem aktiven Kühlsystem versehen ist, um die Wärme von dem zumindest einen optischen Element (A1) abzuführen, wobei das zumindest eine optische Element (A1) mit dem zumindest einen Halteelement (B1) mittels eines wärmeleitenden Verbindungselements oder -mittels (C1) verbunden ist, **dadurch gekennzeichnet, dass** das zumindest eine Halteelement (B1) beweglich in Bezug auf die Tragstruktur ist.

2. Optisches Bauteil nach Anspruch 1, **dadurch gekennzeichnet, dass** das zumindest eine Halteelement (B1) mit einem Kühlmittel beaufschlagbar ist.

3. Optisches Bauteil nach Anspruch 2, **dadurch gekennzeichnet, dass** das zumindest eine Halteelement (B1) zumindest einen Kanal (B2) aufweist, um das Kühlmittel durch das Halteelement (B1) zu leiten.

4. Optisches Bauteil nach Anspruch 3, **dadurch gekennzeichnet, dass** eine Wand des zumindest einen Halteelements (B1), in der der zumindest eine Kanal (B2) vorhanden ist, einen vergrößerten Überlappbereich aufweist, der mit dem zumindest einen optischen Element (A1) überlappt.

5. Optisches Bauteil nach Anspruch 4, **dadurch gekennzeichnet, dass** die Wandstärke der Wand des zumindest einen Halteelements (B1) zumindest in dem Überlappbereich derart verdünnt ist, dass der zumindest eine Kanal (B2) vom optischen Element (A1) durch die Wand nahe beabstandet ist.

6. Optisches Bauteil nach einem der Ansprüche 1 bis 5, **dadurch gekennzeichnet, dass** das zumindest eine optische Element (A1) ein Substrat aufweist, wobei das Substrat ein hoch wärmeleitfähiges Material aufweist.

7. Optisches Bauteil nach einem der Ansprüche 1 bis 6, **dadurch gekennzeichnet, dass** das zumindest eine optische Element (A1) eine optisch wirksame Schicht aufweist, wobei die Schicht ein hoch wärmeleitfähiges Material aufweist.

8. Optisches Bauteil nach einem der Ansprüche 1 bis 7, **dadurch gekennzeichnet, dass** das wärmeleitfähige Element oder Mittel (C1) durch ein wärmeleitfähiges Haftmittel, durch Löten oder Schweißen, oder durch eine wärmeleitfähige mechanische Verbindung bereitgestellt ist.

9. Optisches Bauteil nach einem der Ansprüche 1 bis 8, **dadurch gekennzeichnet, dass** das zumindest eine Halteelement (B1) ein Material aufweist, das hoch wärmeleitfähig ist.

10. Optisches Bauteil nach einem der Ansprüche 1 bis 9, **dadurch gekennzeichnet, dass** das zumindest eine Halteelement (B1) mit der Tragstruktur mittels zumindest einer Blattfeder (29, 30, 31) verbunden ist.

11. Optisches Bauteil nach einem der Ansprüche 1 bis 10, **dadurch gekennzeichnet, dass** das zumindest eine Halteelement (B1) mit der Tragstruktur mittels zumindest eines Festkörpergelenks verbunden ist.

12. Optisches Bauteil nach einem der Ansprüche 1 bis 11, **dadurch gekennzeichnet, dass** das zumindest eine Halteelement (B1) mit der Tragstruktur mittels zumindest eines Gleitlagers oder zumindest eines Rollenlagers (28, 32) verbunden ist.

13. Optisches Bauteil nach einem der Ansprüche 1 bis 12, **dadurch gekennzeichnet, dass** ein Heizsystem zum Erwärmen des optischen Bauteils auf eine vorbestimmte Betriebstemperatur vorgesehen ist.

14. Optisches Bauteil nach Anspruch 13, **dadurch gekennzeichnet, dass** das Heizsystem ein berührungsloses Heizsystem ist.

15. Optisches Bauteil nach Anspruch 13 oder 14, **dadurch gekennzeichnet, dass** das Heizsystem ein Wärmeschild aufweist, das das optische Bauteil umgibt.

16. Optisches Bauteil nach Anspruch 2 oder 3 und nach einem der Ansprüche 10 bis 15, **dadurch gekennzeichnet, dass** das Kühlmittel erwärmt werden kann, um das optisches Bauteil auf die vorbestimmte Betriebstemperatur zu erwärmen.

17. Optisches Bauteil nach einem der Ansprüche 1 bis 16, **dadurch gekennzeichnet, dass** das zumindest eine optische Element (A1) ein Spiegel ist und das zumindest eine Halteelement (B1) eine Strebe ist, die zwischen dem Spiegel und der Tragstruktur verläuft.

18. Optisches Bauteil nach Anspruch 17, **dadurch gekennzeichnet, dass** die Tragstruktur ein Ring ist, der den zumindest einen Spiegel umgibt und die Strebe sich zwischen dem zumindest einen Spiegel und dem Ring radial erstreckt.

19. Optisches Bauteil nach einem der Ansprüche 1 bis 18, **dadurch gekennzeichnet, dass** es mehrere optische Elemente (A1) in Form von Kollektorschalen aufweist, die ineinander geschachtelt sind, und wobei mehrere radial gerichtete Speichen die Halteelemente bilden und mit zumindest manchen oder allen Schalen verbunden sind.

20. Optisches Bauteil nach Anspruch 19, **dadurch gekennzeichnet, dass** die Speichen durch einen gemeinsamen äußeren Ring und/oder einen gemeinsamen inneren Ring verbunden sind.

21. Optisches Bauteil nach einem der Ansprüche 1 bis 20, **dadurch gekennzeichnet, dass** es ein Kollektor zur Verwendung in der EUV-Lithografie ist.

## Revendications

1. Composant optique pour un appareil d'exposition de lithographie EUV, comprenant au moins un élément optique optiquement efficace (A1) qui se réchauffe lorsqu'il subit un rayonnement lumineux, et au moins un élément de retenue (B1) pour l'au moins un élément optique (A1) pour retenir l'au moins un élément optique (A1) dans une structure de support, dans lequel l'au moins un élément optique (A1) est relié à l'au moins un élément de retenue (B1) de façon à conduire de la chaleur, et dans lequel l'au moins un élément de retenue (B1) est au moins partiellement pourvu d'un système de refroidissement actif pour transporter de la chaleur à partir de l'au moins un élément optique (A1), dans lequel l'au moins un élément optique (A1) est relié à l'au moins un élément de retenue (B1) au moyen d'un élément ou moyen de liaison conducteur de chaleur (C1), **caractérisé en ce que** l'au moins un élément de retenue (B1) est mobile par rapport à la structure de support.

2. Composant optique selon la revendication 1, **caractérisé en ce que** l'au moins un élément de retenue (B1) peut recevoir une alimentation en agent de refroidissement.

3. Composant optique selon la revendication 2, **caractérisé en ce que** l'au moins un élément de retenue (B1) comprend au moins un canal (B2) pour conduire l'agent de refroidissement à travers l'élément de retenue (B1).

4. Composant optique selon la revendication 3, **caractérisé en ce qu'**une paroi de l'au moins un élément de retenue (B1) dans lequel l'au moins un canal (B2) est présent, comporte une région agrandie de chevauchement chevauchant l'au moins un élément optique (A1).

5. Composant optique selon la revendication 4, **caractérisé en ce que** l'épaisseur de paroi de la paroi de l'au moins un élément de retenue (B1) est amincie au moins dans la région de chevauchement pour que l'au moins un canal (B2) soit espacé de près de l'élément optique (A1) par la paroi.

6. Composant optique selon une quelconque des revendications 1 à 5, **caractérisé en ce que** l'au moins un élément optique (A1) comprend un substrat, dans lequel le substrat comprend un matériau qui possède un haut coefficient de conductibilité de chaleur.

7. Composant optique selon une quelconque des revendications 1 à 6, **caractérisé en ce que** l'au moins un élément optique (A1) comprend une couche optiquement efficace, dans lequel la couche comprend un matériau qui possède un haut coefficient de conductibilité de chaleur.

8. Composant optique selon une quelconque des revendications 1 à 7, **caractérisé en ce que** l'élément ou le moyen conducteur de chaleur (C1) est fourni par un adhésif conducteur de chaleur, par brasage ou soudage ou une liaison mécanique conductrice de chaleur.

9. Composant optique selon une quelconque des revendications 1 à 8, **caractérisé en ce que** l'au moins un élément de retenue (B1) comprend un matériau qui possède un haut coefficient de conductibilité de chaleur.

10. Composant optique selon une quelconque des revendications 1 à 9, **caractérisé en ce que** l'au moins un élément de retenue (B1) est relié à la structure de support au moyen d'au moins un ressort à lames (29, 30, 31).

11. Composant optique selon une quelconque des revendications 1 à 10, **caractérisé en ce que** l'au moins un élément de retenue (B1) est relié à la structure de support au moyen d'au moins un joint de corps solide.

12. Composant optique selon une quelconque des revendications 1 à 11, **caractérisé en ce que** l'au moins un élément de retenue (B1) est relié à la structure de support au moyen d'au moins un palier à coulissement ou au moins un palier à rouleaux (28, 32).

13. Composant optique selon une quelconque des revendications 1 à 12, **caractérisé en ce qu'**un système de chauffage est fourni pour réchauffer le composant optique jusqu'à une température de fonctionnement prédéterminée.

14. Composant optique selon la revendication 13, **caractérisé en ce que** le système de chauffage est un système de chauffage sans contact.

15. Composant optique selon la revendication 13 ou 14, **caractérisé en ce que** le système de chauffage comprend un écran de chauffage entourant le composant optique.

16. Composant optique selon la revendication 2 ou 3 et une quelconque des revendications 10 à 15, **caractérisé en ce que** l'agent de refroidissement peut être chauffé pour chauffer le composant optique jusqu'à la température de fonctionnement prédéterminée.

17. Composant optique selon une quelconque des revendications 1 à 16, **caractérisé en ce que** l'au moins un élément optique (A1) est un miroir, et l'au moins un élément de retenue (B1) est une entretoise s'étendant entre le miroir et la structure de support.

18. Composant optique selon la revendication 17, **caractérisé en ce que** la structure de support est un anneau entourant l'au moins un miroir, et l'entretoise s'étend radialement entre l'au moins un miroir et l'anneau.

19. Composant optique selon une quelconque des revendications 1 à 18, **caractérisé en ce qu'**il comprend une pluralité d'éléments optiques (A1) en forme d'enveloppes de collecteur emboîtées les unes dans les autres, et dans lequel une pluralité de rayons dirigés radialement forment l'élément de retenues et sont reliés à au moins certaines ou chacune des enveloppes.

20. Composant optique selon la revendication 19, **caractérisé en ce que** les rayons sont reliés à un anneau extérieur commun et/ou un anneau intérieur commun.

21. Composant optique selon une quelconque des revendications 1 à 20, **caractérisé en ce qu'**il est un collecteur destiné à être utilisé dans la lithographie EUV.
